# EUROPEAN PATENT SPECIFICATION

(11) **EP 3 780 067 B1**
(45) Date of publication and mention of the grant of the patent: **09.07.2025**
(21) Application number: 19777812.9
(22) Date of filing: 27.03.2019
(51) Int. Cl.: H01L 21/28, H10D 30/01, H10D 30/66, H10D 30/68, H10D 64/00

(54) **TRENCHED SPLIT-GATE DEVICE AND METHOD FOR MANUFACTURING SAME**
SPLIT-GATE-VORRICHTUNG MIT GRÄBEN UND VERFAHREN ZUR HERSTELLUNG DAVON
DISPOSITIF À GRILLE DIVISÉE À TRANCHÉE ET SON PROCÉDÉ DE FABRICATION

(30) Priority: 27.03.2018 CN 201810259783
(43) Date of publication of application: 17.02.2021
(73) Proprietor: CSMC Technologies Fab2 Co., Ltd., Jiangsu 214028 (CN)
(72) Inventor: FANG, Dong, Jiangsu 214028 (CN); BIAN, Zheng, Jiangsu 214028 (CN)
(74) Representative: Noble, Nicholas
(86) International application number: PCT/CN2019/079932
(87) International publication number: WO 2019/184957

(56) References cited:
- CN-A- 101 847 655
- CN-A- 105 244 374
- CN-A- 105 895 516
- US-A1- 2016 093 719
- US-A1- 2017 263 752

## Description

### TECHNICAL FIELD

The application relates to the technical field of semiconductor manufacturing, in particular to a trench split-gate device and a method for manufacturing the same.

### BACKGROUND

Since the split-gate device structure was put forward, due to the advantages of the split-gate structure with low resistance and low gate capacitance etc., there is a trend that the products of medium and low voltage ordinary trench type VDMOS (vertical double diffused metal oxide semiconductor field-effect transistor) are gradually replaced by the trench split-gate VDMOS devices.

At present, after a thin oxide layer is grown using thermal oxidation method or thermal oxidation, the lower part of the oxide layer in the trench can be realized by growing an oxide layer on the surface of the thin oxide layer using furnace tube oxidation method or deposition method. With the oxide layer grown by the above methods, the thickness of the oxide layer at the bottom of the trench is usually thinner than that of the oxide layer on the side wall of the trench. With the increase of the thickness of the oxide layer at the bottom of the trench and the increase of the depth of the trench, the ratio of the thickness of the oxide layer at the bottom and the thickness of the oxide layer on the side wall of the trench trends to decrease. When a reverse voltage is applied across the source end and drain end of VDMOS, a thicker oxide layer at the bottom of the trench is required to adapt to withstand voltage. Because the thickness of the oxide layer at the bottom of the trench is less than that of the oxide layer on the side wall oxide layer of the trench, the oxidation process is increased in order to achieve a thicker oxide layer at the bottom of the trench, which causes the thickness of the oxide layer on the side wall of the trench is thicker and a wider trench is required to adapt to the thicker oxide layer on the side wall of the trench. Accordingly, the area of chip is larger and the specific on resistance is higher.

US2016/093719A1 describes a semiconductor device which including: a first semiconductor region; a second semiconductor region selectively provided on the first semiconductor region; a third semiconductor region selectively provided on the second semiconductor region; a first electrode provided on the third semiconductor region and connected to the third semiconductor region; a second electrode electrically connected to the first semiconductor region; a third electrode provide via an insulating film on the first semiconductor region, the second semiconductor region, and the third semiconductor region; and a fourth electrode provided on the second electrode side of the third electrode, the fourth electrode being provided via the insulating film on the first semiconductor region. The insulating film has three or more regions between the fourth electrode and the first semiconductor region. Width of each of the regions in a direction crossing a direction from the third electrode toward the second electrode is different.

US2017/263752A describes a semiconductor device includes a first semiconductor region of a first conductivity type, a second semiconductor region of a second conductivity type on the first semiconductor region, a first electrode surrounded by the first semiconductor region and including a first electrode portion and a second electrode portion provided on the first electrode portion, and a first insulating section including first and second insulating portions. The second insulating portion is arranged side by side with the second electrode portion in a second direction perpendicular to a first direction from the first semiconductor region to the second semiconductor region. The first insulating portion is arranged side by side with the first electrode portion in the second direction. A length and a thickness of the first insulating portion in the first direction are greater than a length and a thickness of the second insulating portion in the first direction, respectively.

### SUMMARY

According to various embodiments of the present disclosure, a trench split-gate device and a method for manufacturing the same are provided. The invention is set out in the appended set of claims.

According to one aspect of the present disclosure, a method for manufacturing a trench split-gate device is provided, which comprises: etching a semiconductor substrate to form a trench; depositing oxide in the trench to form a floating gate oxide layer, in which the floating gate oxide layer is gradually thickened from top to bottom along a side wall of the trench, and a thickness of the floating gate oxide layer at a lower part of the side wall of the trench is the same as that of the floating gate oxide layer at a bottom of the trench; depositing polysilicon into the trench to form a floating gate polycrystalline layer; growing an insulating medium on an upper surface of the floating gate polycrystalline layer to form an isolation layer; and forming a control gate on the isolation layer in the trench.

According to another aspect of the present disclosure, a trench split-gate device is provided, which includes: a semiconductor substrate in which a trench is provided; a floating gate oxide layer provided on an inner wall of the trench, a thickness of the floating gate oxide layer being gradually increased along the side wall of the trench to a bottom of the trench, and the thickness of the floating gate oxide layer at a lower part of the side wall of the trench being the same as that of the floating gate oxide layer at the bottom of the trench; a floating gate polycrystalline layer provided on a surface of the floating gate oxide layer; an isolation layer provided on the floating gate polycrystalline layer, and a control gate provided on the isolation layer to control the on and off of the device.

The details of one or more embodiments of the invention are set forth in the accompanying drawings and the description below. Other features, objects, and advantages of the invention will be apparent from the description and drawings, and from the claims.

### BRIEF DESCRIPTION OF THE DRAWINGS

In order to better describe and explain the embodiments or examples of those applications disclosed herein, reference can be made to one or more drawings. The additional details or examples used to describe the drawings should not be considered to limit the scope of any of the disclosed inventions, the embodiments and/or examples currently described, and the best model of these applications as currently understood.
FIG 1 is a flow chart of a method for manufacturing a trench split-gate device provided by an embodiment non forming part of the present invention;
FIG 2 is a flow chart of a method for manufacturing a trench split-gate device provided by a specific embodiment non forming part of the present invention;
FIG. 3A ~ FIG. 3G are schematic sectional views of the cell of the trench split-gate device manufactured by the method in FIG 2;
FIG 4 is a flow chart of the method for manufacturing a trench split-gate device provided by another specific embodiment according to the present invention;
FIG. 5A ~ 5H are schematic sectional views of the cell of trench split-gate devices manufactured by the method in FIG 4.

### DETAILED DESCRIPTION OF THE EMBODIMENTS

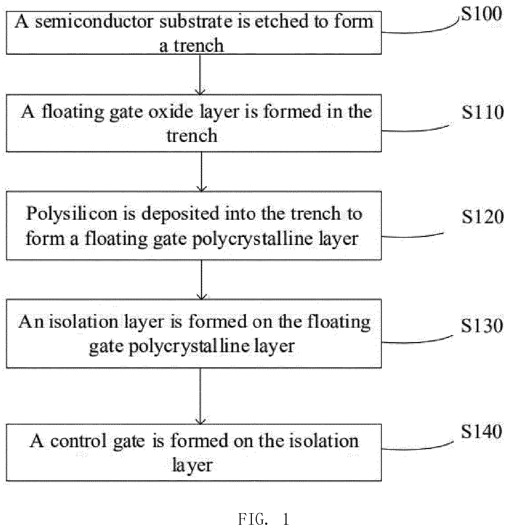

As shown in FIG 1, a method for manufacturing a trench split-gate device is provided by the present disclosure, which comprises the following steps:
At S100: a semiconductor substrate is etched to form a trench.
At S110: an oxide is deposited in the trench to form a floating gate oxide layer, in which the floating gate oxide layer is gradually thickened from top to bottom along the side wall of the trench, and a thickness of the floating gate oxide layer at the lower part of the side wall of the trench is the same as that of the floating gate oxide layer at the bottom of the trench.
At S120: polysilicon is deposited into the trench to form a floating gate polycrystalline layer.
At S130: an insulating medium is grown on the upper surface of the floating gate polycrystalline layer to form an isolation layer.
At S140: a control gate is formed on the isolation layer in the trench.

In the above method for manufacturing a trench split-gate device, a gradually changing floating gate oxide layer is grown on the trench side wall, in order that the thickness of the floating gate oxide layer is gradually increased from the isolation layer position to the bottom position of the trench and the thickness of the floating gate oxide layer at the lower part of the side wall of the trench is the same as that of the floating gate oxide layer at the bottom of the trench. The thickness of the floating gate oxide gradually changing can reduce the width of the trench and further reduce the cell area and the specific on resistance of the device. In addition, the thickness of the floating gate oxide layer is gradually increased from the side wall of the trench, and the thickness of the floating gate oxide at the lower part of the side wall of the trench is the same as that at the bottom of the trench. Said floating gate oxide layer also adapts to the continually increasing voltage from the control gate to the bottom of the trench, such that the device will not be broken down due to a non-adaptive voltage.

In one of embodiments, etching the semiconductor substrate to form a trench specifically comprises: etching the semiconductor substrate vertically to make the side wall of the trench vertical up and down. The step of depositing an oxide into the trench to form a floating gate oxide layer comprises: forming a first oxide layer on the inner surface of the trench; forming a second oxide layer on the first oxide layer using high density plasma chemical vapor deposition process in which the thickness of the second oxide layer is controlled to gradually increase from top to bottom along the trench side wall and the thickness of the second oxide layer at the lower part of the side wall of the trench is the same as that of the second oxide layer at the bottom of the trench. In the example, by controlling the pressure of the reaction chamber and the flow rate of the reaction gas flowing into the reaction chamber, the thickness of the second oxide layer along the side wall of the trench can be controlled to gradually increase.

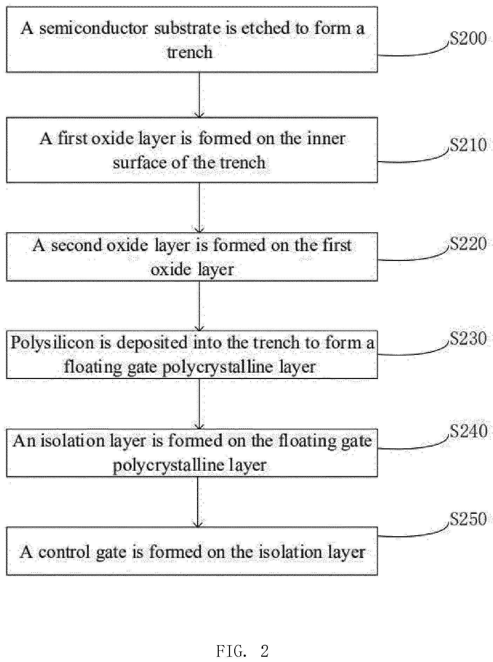

Specifically, referring to FIG 2, the method for manufacturing the trench split-gate device according to the embodiment specifically comprises the following steps:
At S200: a semiconductor substrate is etched to form a trench.

A semiconductor substrate is a kind of semiconductor material, which provides mechanical supports and electrical properties for manufacturing a transistor and an integrated circuit. In the present embodiment, the semiconductor substrate can include semiconductor elements such as monocrystal, polycrystalline, or amorphous silicon or germanium, and can also include a mixed semiconductor structure such as silicon carbide, indium antimonide, lead telluride, indium arsenide, indium phosphide, gallium arsenide or gallium antimonide, alloy semiconductors or combinations thereof.

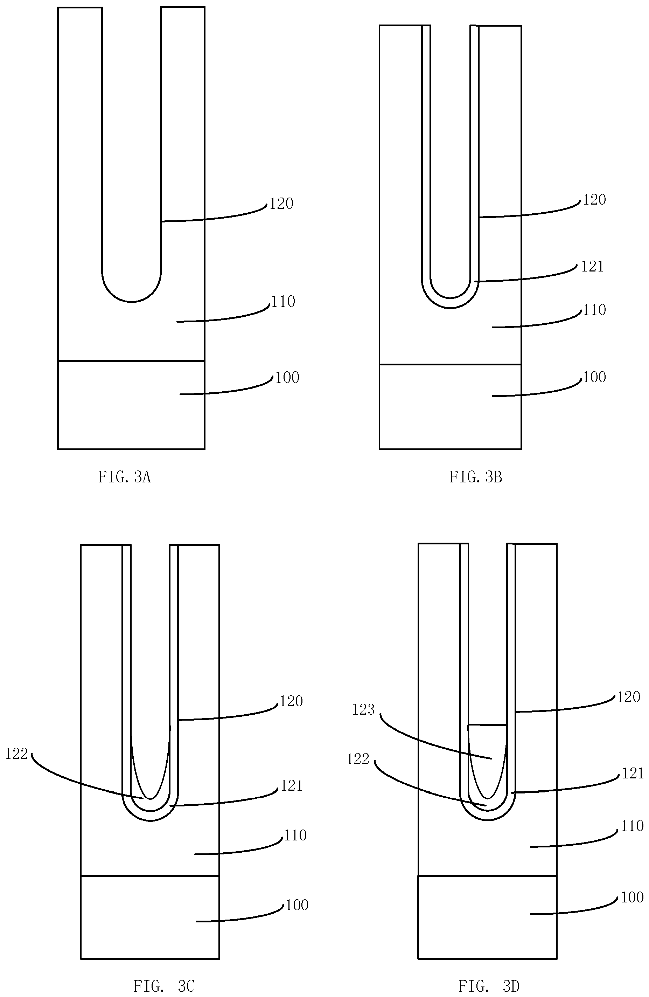

Specifically, referring to FIG 3A, the semiconductor substrate includes a highly doped bulk layer 100 and a lightly doped epitaxial layer 110. The doping types of the bulk layer 100 and the epitaxial layer 110 are the same, which can be N-type impurity. In this disclosure, the epitaxial layer 110 is etched vertically from top to bottom using dry etching process in order that the side wall of the trench 120 formed by etching is vertical up and down.

At S210: a first oxide layer is formed on the inner surface of the trench.

In the embodiment, a first oxide layer can be formed on the inner surface of the trench using the furnace tube oxidation method, and the first oxide layer can be silicon oxide.

Specifically, the semiconductor substrate can be placed in a certain gas atmosphere and a certain temperature range to have the semiconductor substrate react with oxygen or water vapor to generate silicon dioxide during the preparation. The gas atmosphere refers to nitrogen and/or oxygen and/or hydrogen, and the temperature range is from about 700°C raised to about 1100°C and then back to about 700°C. As shown in FIG 3B, in the embodiment, the thickness of the first oxide layer 121 in the trench 120 is the same everywhere.

At S220: a second oxide layer is formed on the first oxide layer using high density plasma chemical vapor deposition process. By controlling the pressure of the reaction chamber and the flow rate of the reaction gas flowing into the reaction chamber, the thickness of the second oxide layer is gradually increased from top to bottom along the side wall of the trench, and the thickness of the second oxide layer at the lower part of the side wall of the trench is the same as that of the second oxide layer at the bottom of the trench.

As shown in FIG 3C, after the preparation of the first oxide layer 121 is completed, a second oxide layer 122 is deposited on the surface of the first oxide layer 121 at the bottom of the trench 120 using high density plasma chemical vapor deposition (HDP CVD) process, in which the second oxide layer 122 can be silicon oxide. During the preparation, silane, oxygen, hydrogen, helium and the like reaction gases flow into the reaction chamber. During the deposition process, by controlling the pressure of the reaction chamber and the flow rate of the reaction gas flowing into the reaction chamber, the amount of silicon dioxide attached to the side wall and the bottom of the trench 120 generated by the reaction is controlled. Firstly, a certain amount of reaction gas flows into the reaction chamber under a certain pressure. The reaction gas reaches the bottom of the trench 120 under the pressure of the cavity, and reacts at the bottom of the trench 120 to generate oxidation products with thicker thickness. Then, the pressure is reduced at regular intervals and the flow rate of the reaction gas flowing into the reaction chamber is reduced. At a lower pressure, the reaction gas is gradually raised and a deposition reaction is taken place on the side wall of the trench 120 to generate oxidation products with thinner thickness. Further, the thickness of the second oxide layer 122 deposited on the side wall of the trench 120 is gradually reduced from bottom to up. The thickness of the second oxide layer 122 at the lower part of the side wall of the trench 120 is the same as that of the second oxide layer 122 deposited at the bottom the trench 120. Therefore, the thickness of the floating gate oxide constituted of the first oxide layer 121 and the second oxide layer 122 is gradually increased from top to bottom along the side wall of the trench, and the thickness of the floating gate oxide layer at the lower part of the side wall of the trench is the same as that of the floating gate oxide layer at the bottom of the trench. In the present embodiment, the flow rate of the reaction gas can be 15% - 20% for silane, 20% - 25% for oxygen, 25% - 35% for hydrogen and 20% - 40% for helium.

Compared with the ordinary atmospheric pressure chemical vapor deposition method, the thickness of the second oxide layer 122 formed by the deposition can be controlled by the HDP CVD process used in the embodiment of present disclosure, such that the thickness of the second oxide layer 122 deposited on the side wall of the trench 120 is gradually increased from the top to the bottom, and the thickness of the second oxide layer 122 at the bottom of the trench 120 is the same as that of the second oxide layer 122 at the lower part of the side wall of the trench 120. On the one hand, increasing the thickness of the floating gate oxide at the bottom of the trench can make the device adapt to withstand voltage and avoid the device to be broken down by high voltage. On the other hand, under the condition that the thickness of the floating gate oxide at the bottom of the trench is the same, the floating gate oxide layer on the side wall of the trench in the present disclosure is thinner than the floating gate oxide layer on the side wall of the trench in a traditional process, and the width of the trench is smaller than that of the trench in a traditional process. Therefore the cell area is reduced, the number of cell per unit area on the chip is increased and the specific on resistance of the device is reduced.

At S230: polysilicon is deposited into the trench to form a floating gate polycrystalline layer.

Referring to FIG 3D, in the embodiment, polysilicon can be deposited in the trench using low-pressure chemical vapor deposition method to form a floating gate polycrystalline layer 123. After the polysilicon is filled in the trench 120, the polysilicon can be etched back or ground in order that the upper surface of the floating gate polycrystalline layer 123 is lower than the lower surface of the P-type well region formed in the subsequent process.

At S240: an insulating medium is grown on the surface of floating gate polycrystalline layer to form an isolation layer.

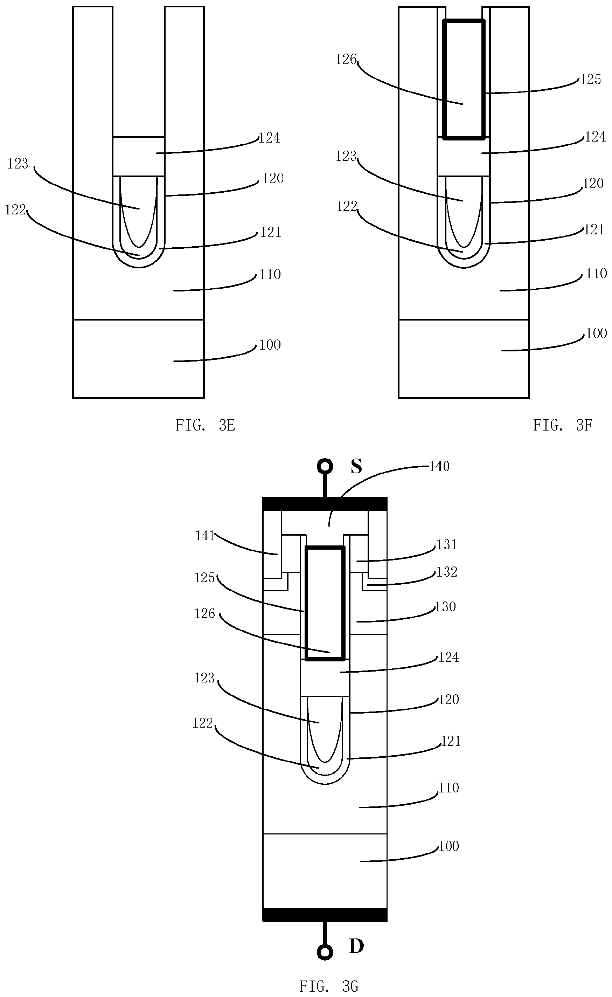

Referring to FIG 3E, in this embodiment, insulating medium may be grown on the surface of the floating gate polycrystalline layer 123 using thermal oxidation method or chemical vapor deposition method to form an isolation layer 124, in which the insulating medium can be silicon nitride, silicon oxide or silicon oxynitride, and the isolation layer 124 is used to isolate the floating gate polycrystalline layer 123 from the control gate formed in the subsequent process.

Further, before the step of forming the isolation layer 124 on the upper surface of the floating gate polycrystalline layer 123, the method further comprises a step of removing the first oxide layer 121 above the floating gate polycrystalline layer 123. Specifically, the first oxide layer 121 above the floating gate polycrystalline layer 123 can be removed using dry etching technology.

At S250: a control gate is formed on the isolation layer in the trench.

Further, referring to FIG 3F, the step of forming a control gate on the isolation layer 124 in the trench 120 specifically includes: forming a control gate oxide layer 125 on the trench side wall above the isolation layer 124; forming a control gate polycrystalline layer 126 by depositing the polysilicon on the isolation layer 124 in the trench 120 where the control gate polycrystalline layer 126 is adjacent to the control gate oxide layer 125; etching back or grinding the control gate polycrystalline layer 126. The control gate is constituted by the control gate oxide layer 125 and the control gate polycrystalline layer 126 together.

Specifically, in the present embodiment, the polysilicon can be deposited in the trench 120 using low-pressure chemical vapor deposition method, and the polysilicon is doped at the same time. The polysilicon outside the trench 120 can be etched using dry etching process to form a control gate.

In the method for manufacturing a trench split-gate device provided by the embodiment, by using the high-density plasma chemical vapor deposition process, the thickness of the second oxide layer at the bottom and on the side wall of the trench can be adjusted by adjusting the pressure of the reaction chamber and the flow rate of the reaction gas. The thickness of the floating gate oxide on the side wall of the trench is gradually increased from top to bottom, and the thickness of the floating gate oxide at the lower part of the side wall of the trench is the same as that of the floating gate oxide at the bottom of the trench. Therefore, on the one hand, it can meet the requirement of withstanding the gradually changing voltage, and at the same time, the width of the trench can be reduced by the gradually changing thickness of the floating gate oxide, thereby further reducing the cell area, increasing the number of cell receivable per unit area on the chip, and reducing the specific on resistance of the device.

Referring to FIG 3G, after the step of forming a control gate on the isolation layer in the trench, the method further comprises: forming a P-type well region 130 by injecting the P-type impurity to both sides of the trench 120. An N-type heavily doped region 131 is formed in the P-well region 130 on both sides of the trench 120 by injecting a highly doped N-type impurity. Then, an isolation oxide layer 140 is formed on the control gate using thermal oxidation method. The isolated oxide layer 140 is etched to form a contact hole 141 penetrating the P-type well region, and the N-type heavily doped region 131 is located between the contact hole 141 and the trench 120. Heavily doped P-type impurity is injected into P-well region through the contact hole 141 to form a P-type heavily doped region 132. After that, the contact hole 141 is filled, and finally a source electrode is formed on the isolation oxide layer 140, and a drain electrode is formed on the lower surface of the bulk layer 100, and thus the basic structure of the trench split-gate device is formed.

A trench split-gate device is also provided by the embodiment, which is manufactured according to the steps of the method shown in FIG 2. Specifically, as shown in FIG 3G, the trench split-gate device includes a semiconductor substrate, which includes a bulk layer 100 and an epitaxial layer 110. A trench 120 is provided in the semiconductor substrate, the trench 120 is arranged in the epitaxial layer 110, and the side wall of the trench 120 is vertical up and down. The inner wall of the trench 120 is provided with a floating gate oxide layer. The floating gate oxide includes a first oxide layer 121 on the inner wall of the trench 120 and a second oxide layer 122 on the first oxide layer 121. The thickness of the first oxide layer 121 on the side wall of the trench 120 is uniform everywhere, the thickness of the second oxide layer 122 is gradually increased from top to bottom along the side wall of the trench 120, and the thickness of the second oxide layer 122 at the lower part of the side wall of the trench 120 is the same as that of the second oxide layer 122 at the bottom of the trench 120. Therefore, the total thickness of the floating gate oxide constituted of the first oxide layer 121 and the second oxide layer 122 is gradually increased from top to bottom along the side wall of the trench 120, and the thickness of the floating gate oxide layer at the lower part of the side wall of the trench 120 is the same as that of the floating gate oxide layer at the bottom of the trench 120. A floating gate polycrystalline layer 123 is provided on the surface of the floating gate oxide layer. A floating gate structure is constituted of floating gate polycrystalline layer 123 and floating gate oxide layer together. The upper surface of the floating gate polycrystalline layer 123 is provided with an isolation layer 124. A control gate polycrystalline layer 126 and a control gate oxide layer 125 are provided on the isolation layer 124. A control gate structure is constituted of the control gate polycrystalline layer 126 and the control gate oxide layer 125 together.

In the trench split-gate device provided by the embodiment of the disclosure, the second oxide layer is formed using HDP CVD process at the bottom and on side wall of the trench, such that the thickness of the second oxide layer is gradually increased from top to bottom along the side wall of the trench, and the thickness of the second oxide layer at the lower part of the side wall of the trench is the same as that of the second oxide layer at the bottom of the trench. Furthermore, the total thickness of the floating gate oxide constituted of the first oxide layer and the second oxide layer is gradually increased from top to bottom along the side wall of the trench, and the thickness of the floating gate oxide layer at the lower part of the side wall of the trench is the same as that of the floating gate oxide layer at the bottom of the trench. Therefore, on the one hand, it can meet requirement of withstanding the gradually changing voltage, and at the same time, the width of the trench can be reduced by the gradually changing thickness of the floating gate oxide, and thus the cell area is further reduced and the specific on resistance of the device is reduced.

In another embodiment, the step of etching a semiconductor substrate to form a trench specifically comprises: etching the semiconductor substrate to form a vertical upper half trench. The semiconductor substrate is etched obliquely downward from the bottom of the upper half trench to form a lower half trench extending downward from the bottom of the half trench and with a width gradually increased from the top to the bottom. And the bottom of the lower half trench is concave arc-shaped. The step of depositing oxide into the trench to form a floating gate oxide layer includes: forming a first oxide layer on the inner surface of the trench; etching the first oxide layer to make the side wall of the first oxide layer vertical up and down; forming a second oxide layer on the first oxide layer at the bottom of the lower half trench using high density plasma chemical vapor deposition process, in which the thickness of the floating gate oxide layer constituted of the first oxide layer and the second oxide layer is gradually increased from top to bottom along the side wall of the trench. The thickness of the floating gate oxide at the lower part of the side wall of the lower half of the trench is the same as that of the floating gate oxide at the bottom of the lower half of the trench.

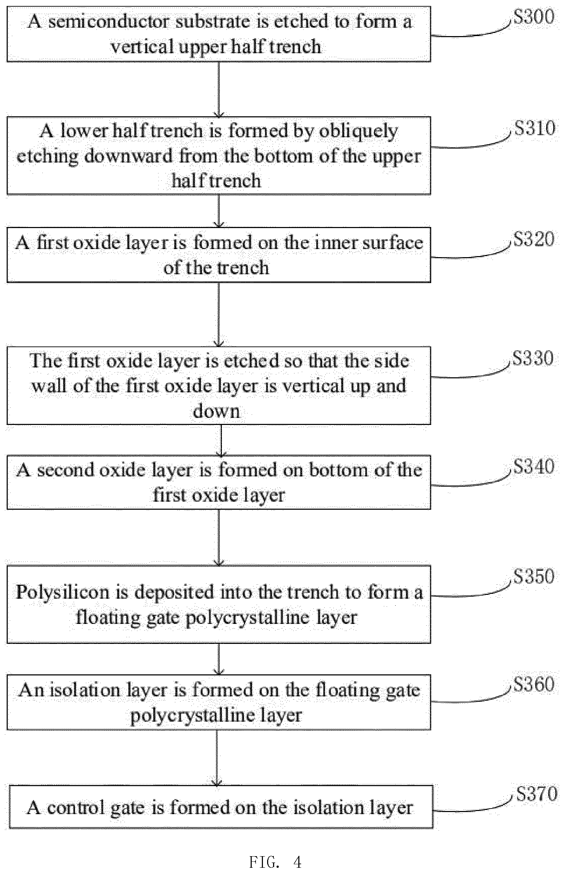

Specifically, referring to FIG 4, in the present embodiment, the method for manufacturing the trench split-gate device specifically includes the following steps:
At S300: a semiconductor substrate is etched to form a vertical upper half trench.

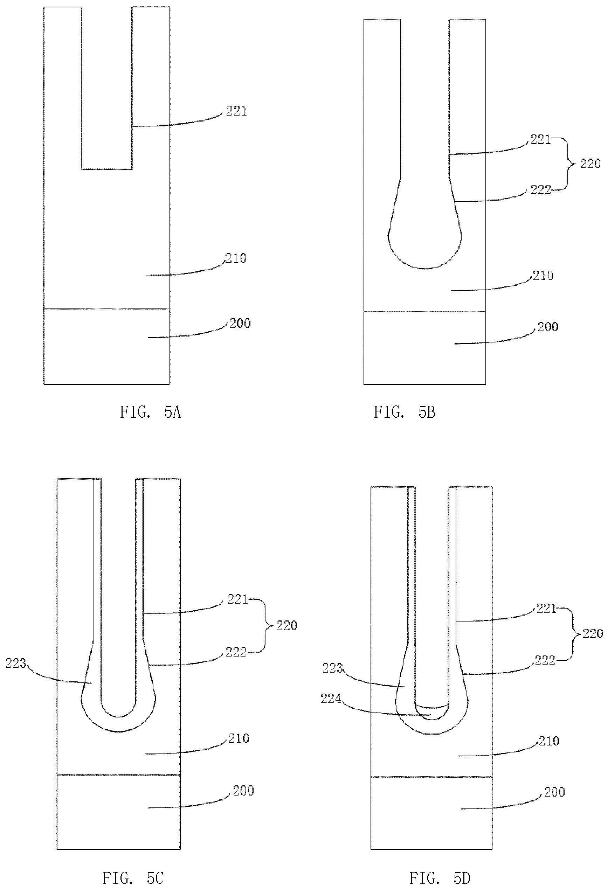

Referring to FIG 5A, the semiconductor substrate includes a bulk layer 200 and an epitaxial layer 210. In this embodiment, the semiconductor substrate is vertically etched using dry etching technique to form a vertically downward upper half trench 221 in the epitaxial layer 210. During the etching process, the polymer generated by the reaction of the etching gas and the silicon substrate is reserved to protect the upper half trench 221, so that the surface of the upper half trench 221 will not be etched when proceeding with the next step.

At S310: the semiconductor substrate is etched obliquely downward from the bottom of the upper half trench to form a lower half trench extending downward from the bottom of the upper half trench and with a width gradually increased from the top to the bottom.

Referring to FIG 5B, similarly using the dry etching technology, the epitaxial layer 210 is etched obliquely downward from the bottom of the vertical upper trench 221 to form the lower half trench 222 extending downward from the bottom of the upper half trench 221 and with a width gradually increased from the top to the bottom, and the bottom of the lower half trench 222 is concave arc-shaped. The trench 220 is constituted of the upper half trench 221 and the lower half trench 222 together. After the etching of trench 220 is completed, the step of acid pickling is carried out to remove the polymer attached on the surface of trench 220 generated by etching.

At S320: a first oxide layer is formed on the inner surface of the trench.

Referring to FIG 5C, a first oxide layer 223 can be oxidizedly formed on the inner surface of trench 220 using furnace tube oxidation method or CVD process. Specifically, in the present embodiment, the first oxide layer 223 is grown by oxidizing on the surface of trench 220 using furnace tube oxidation method.

At S330: the first oxide layer is etched to enable the side wall of the first oxide layer vertical up and down.

After the growing process is completed, the first oxide layer 223 is dry etched, so that the side wall of the first oxide layer 223 of the inner wall of the trench is vertical up and down, and the thickness of the first oxide layer 223 of the side wall of the lower half trench 222 is gradually increased from top to bottom.

At S340: a second oxide layer is formed on the first oxide layer at the bottom of the lower half trench using high density plasma chemical vapor deposition process, in which the thickness of the floating gate oxide layer formed by the combination of the first oxide layer and the second oxide layer gradually increased from top to bottom along the side wall of the trench, and the thickness of the floating gate oxide layer at the lower part of the side wall of the trench is the same as that of the floating gate oxide layer at the bottom of the trench.

Referring to FIG 5D, a second oxide layer 224 is deposited on the first oxide layer 223 at the bottom of the lower half trench 222 using HDP CVD deposition method to thicken the floating gate oxide layer at the bottom of the lower half trench 222 and enhance the performance of the device withstanding voltage. Since the thickness of the first oxide layer 223 on the side wall of the lower half trench 222 gradually increases from top to bottom along the lower half trench 222, and the second oxide layer 224 is located on the first oxide layer 223 at the bottom of the lower half trench 222, the total thickness of the floating gate oxide layer formed by the first oxide layer 223 and the second oxide layer 224 gradually increases from top to bottom along the side wall of the lower half trench 222, and the thickness of the floating gate oxide layer at the lower part of the side wall of the lower half trench 222 is the same as that of the floating gate oxide at the bottom of half trench 222.

At S350: polysilicon is deposited into the trench to form a floating gate polycrystalline layer.

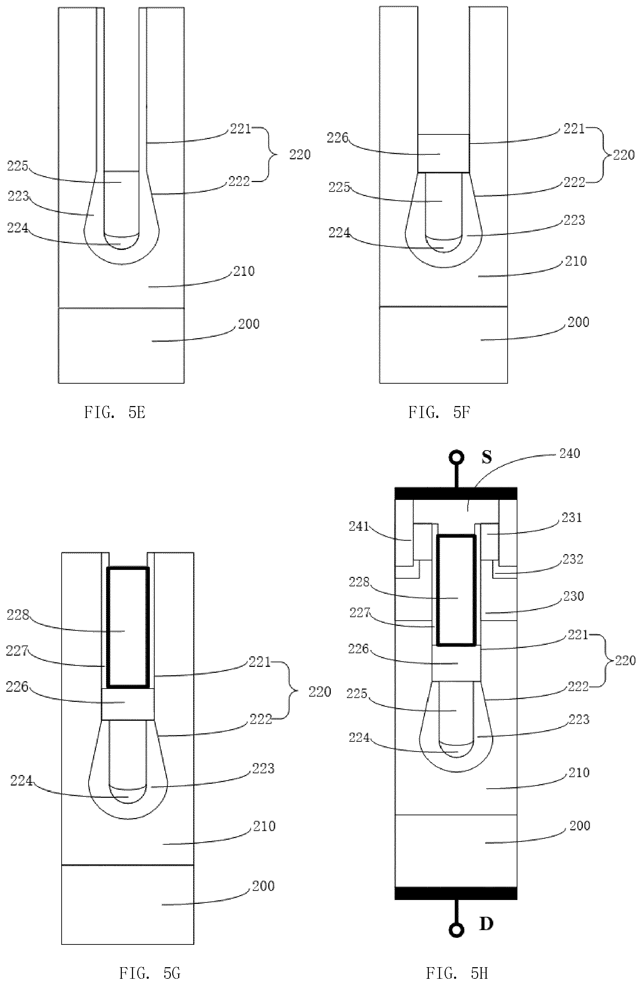

As shown in FIG 5E, in the present embodiment, polysilicon can be deposited in the trench 220 using low-pressure chemical vapor deposition method to form a floating gate polycrystalline layer 225. Furthermore, after the polysilicon is filled in the trench 220, the polysilicon can be etched back or ground in order that the upper surface of the floating gate polycrystalline layer 225 is lower than the lower surface of the P-type well region formed in the subsequent processes.

At S360: an insulating medium is grown on the surface of the floating gate polycrystalline layer to form an isolation layer.

As shown in FIG 5F, insulating medium can be deposited on the surface of floating gate polycrystalline layer 225 using thermal oxidation method or chemical vapor deposition method to form an isolation layer 226. The insulating medium can be silicon nitride or silicon oxide or silicon oxynitride, which is used for isolating the floating gate polycrystalline layer 225 and the control gate formed in subsequent processes.

Further, before the step of forming an isolation layer 226 on the upper surface of the floating gate polycrystalline layer 225, the method can further include the step of removing the first oxide layer 222 above the floating gate polycrystalline layer 225. Specifically, the first oxide layer 223 above the floating gate polycrystalline layer 225 can be removed using dry etching technology.

At S370: a control gate is formed on the isolation layer in the trench.

Further, as shown in FIG 5G, forming a control gate on the isolation layer 226 in the trench 220 specifically includes: forming a control gate oxide layer 227 on the side wall of the trench above the isolation layer 226; depositing polysilicon on the isolation layer 226 in the trench 220 to form a control gate polycrystalline layer 228 in which the control gate polycrystalline layer 228 is adjacent to the control gate oxide layer 227; and etching back or grinding the control gate polycrystalline layer 228 to form the control gate, where the control gate includes a control gate oxide layer 227 and a control gate polycrystalline layer 228.

Specifically, in this embodiment, polysilicon can be deposited in trench 220 using low-pressure chemical vapor deposition method, and polysilicon is doped at the same time. The polysilicon outside the trench 220 can be etched using dry etching process to form the control gate.

In the method for manufacturing the trench split-gate device provided by the present embodiment, the lower half trench with the width gradually increased from the top to the bottom is formed by etching the vertical upper half trench firstly and then etching obliquely downward from the bottom of the upper half trench. The trench is constituted by the upper half trench and the lower half trench together. Then a first oxide layer is grown on the inner side of the trench, in which the thickness of the first oxide layer in the lower half trench gradually increases from top to bottom along the side wall of the lower half trench. Next, a second oxide layer is deposited on the first oxide layer at the bottom of the lower half trench to increase the thickness of the floating gate oxide layer at the bottom of the lower half trench, in order that the total thickness of the floating gate oxide layer constituted of the first oxide layer and the second oxide layer is gradually increase from top to bottom along the side wall of the lower half trench, and the thickness of the floating gate oxide layer at the lower part of the lower half trench is the same as that of the floating gate oxide layer at the bottom of the lower half trench. Therefore, on the one hand, it can meet the requirement of withstanding the gradually changing voltage, and at the same time, it can reduce the cell area and the specific on resistance of the device.

Referring to FIG 5H, after the step of forming a control gate on the isolation layer in the trench, the method further includes: forming a P-type well region 230 by injecting the P-type impurity to both sides of the trench 220. An N-type heavily doped region 231 is formed in the P-type well region 230 on both sides of the trench 220 by injecting highly doped N-type impurity. An isolated oxide layer 240 can be formed on the control gate using thermal oxidation method. A contact hole 241 penetrating the P-type well region is formed by etching the isolated oxide layer 240. The N-type heavily doped region 231 is located between the contact hole 241 and the trench 220. A P-type heavily doped region 232 is formed by injecting heavily doped P-type impurity into P-well region through contact hole 241. After that, the contact hole 241 is filled, and finally a source electrode is formed on the isolation oxide layer 240, a drain electrode is formed on the lower surface of the bulk layer 200, and thus a basic structure of the split-gate device is formed.

The present embodiment also provides a trench split-gate device, which is manufactured according to the steps of the method shown in FIG 4. Specifically, as shown in FIG 5H, the trench split-gate device includes a semiconductor substrate. The semiconductor substrate includes a bulk layer 200 and an epitaxial layer 210. A trench 220 is provided in the epitaxial layer 210. The trench 220 includes an upper half trench 221 with side wall vertical up and down and a lower half trench 222 extending downward from the bottom of the upper half trench and with a width gradually increased from the top to the bottom. The bottom of the lower half trench is concave arc-shaped. The inner wall of the trench 220 is provided with an oxide layer, which includes a first oxide layer 223 on the inner wall of the trench and a second oxide layer 224 on the first oxide layer 223 at the bottom of the trench. The thickness of the first oxide layer 223 on the inner wall of the lower half trench 222 is gradually increased from top to bottom along the side wall of the lower half trench 222, and the second oxide layer 224 is used to increase the thickness of the floating gate oxide layer at the bottom of the lower half trench 222. Therefore, the total thickness of the floating gate oxide constituted of the first oxide layer 223 and the second oxide layer 224 is gradually increased from top to bottom along the side wall of the lower half trench 222, and the thickness of the floating gate oxide layer at lower part of the side wall of the lower half trench 222 is the same as that of the floating gate oxide layer at the bottom half trench 222. A floating gate polycrystalline layer 225 is provided on the surface of the floating gate oxide layer. The upper surface of the floating gate polycrystalline layer 225 is provided with an isolation layer 226. The side wall of the upper half trench 221 above the isolation layer 226 is provided with a control gate oxide layer 227. The control gate polycrystalline layer 228 is located on the isolation layer 226 and adjacent to the control gate oxide layer 227. The control gate of the trench split-gate device is constituted by the control gate oxide layer 227 and the control gate polycrystalline layer 228 together.

In the trench split-gate device provided by the embodiment of the invention, the width of the lower half trench is gradually increased from top to bottom, and the thickness of the first oxide layer which is grown on the inner wall of the lower half trench is gradually increased from top to bottom, and the second oxide layer is used to thicken the bottom of the trench, such that the total thickness of the floating gate oxide layer constituted by the first oxide layer and the second oxide layer is gradually increased from top to bottom along the side wall of the lower half trench. The thickness of floating gate oxide at the lower part of the sided wall of the lower half trench is the same as that of the floating gate oxide at the bottom of the lower half trench. Therefore, on the one hand, it can meet the requirement of withstanding the gradually changing voltage. At the same time, the gradually changing thickness of the floating gate oxide can reduce the width of the trench, and further reduce the cell area and the specific on resistance of the device.

It should be understood that although the steps in the flowchart of FIG 1, FIG 2 and FIG 4 are shown in sequence according to the arrow, these steps are not necessarily executed in the order indicated by the arrows. Unless explicitly stated herein, there is no strict sequence restriction on the execution of these steps, which can be performed in other orders. Moreover, at least a part of the steps in FIG 1, FIG 2 and FIG. 4 may include a plurality of sub steps or stages, which are not necessarily completed at the same time, but can be executed at different times, and their execution sequence is not necessarily in sequence, but can be executed in turn or alternately with at least one part of the sub steps or stages of other steps.

## Claims

1. A method for manufacturing a trench split-gate device, comprising:
etching (S300) a semiconductor substrate to form a vertical upper half trench (221);
etching (S310) the semiconductor substrate obliquely downward from a bottom of the upper half trench (221) to form a lower half trench (222) extending downward from the bottom of the upper half trench (221) and with a width that increases from top to bottom, and a bottom of the lower half trench (222) being concave arc-shaped, and a trench (220) being constituted by the upper half trench (221) and the lower half trench (222)together;
forming (S320) a first oxide layer (223) on an inner surface of the trench (220);
etching (S330) the first oxide layer (223) to enable a side wall of the first oxide layer (223)vertical up and down;
forming (S340) a second oxide layer (224) on the first oxide layer (223) at the bottom of the lower half trench (222) using high density plasma chemical vapor deposition process, so that a floating gate oxide layer formed by combination of the first oxide layer (223) and the second oxide layer (224) thickens from top to bottom along a side wall of the lower half trench (222), and the thickness of the floating gate oxide layer at a lower part of the side wall of the lower half trench (222) is the same as that of the floating gate oxide layer at the bottom of the lower half trench (222;
depositing (S350) polysilicon into the trench (220) to form a floating gate polycrystalline layer (225);
growing (S360) an insulating medium on an upper surface of the floating gate polycrystalline layer (225) to form an isolation layer (226); and
forming a control gate on the isolation layer in the trench (220).

2. A trench split-gate device, comprising:
a semiconductor substrate in which a trench (220) is provided; the trench (210) comprising an upper half trench (221) and a lower half trench (222), the upper half trench (221) being vertical up and down, the lower half trench (222) extending downward from the bottom of the upper half trench (221) and with a width that increases from top to bottom, and a bottom of the lower half trench (222) being concave arc-shaped;
a first oxide layer (223) formed on an inner wall of the trench (220); a side wall of the first oxide layer (223) being vertical up and down;
a second oxide layer (224) formed on the first oxide layer (223) at the bottom of the lower half trench (222), a floating gate oxide layer formed by combination of the first oxide layer (223) and the second oxide layer (224) thickens from top to bottom along a side wall of the lower half trench (222), and the thickness of the floating gate oxide layer at a lower part of the side wall of the lower half trench (222) being the same as that of the floating gate oxide layer at the bottom of the lower half trench (222);
a floating gate polycrystalline layer (225) formed on a surface of the floating gate oxide layer;
an isolation layer (226) formed on an upper surface of the floating gate polycrystalline layer (225); and
a control gate formed on the isolation layer (226) configured to control on and off of the device.

3. The trench split-gate device according to claim 2, **characterized in that** a width of the lower half trench (222) increases from a bottom of the isolation layer (226) to a position of a bottom of the lower half trench (222).

## Patentansprüche

1. Verfahren zum Herstellen einer Split-Gate-Vorrichtung mit Gräben, das Folgendes umfasst:
Ätzen (S300) eines Halbleitersubstrats, um einen vertikalen oberen Halbgraben (221) zu bilden;
Ätzen (S310) des Halbleitersubstrats von einem Boden des oberen Halbgrabens (221) schräg nach unten, um einen unteren Halbgraben (222) zu bilden, der sich von dem Boden des oberen Halbgrabens (221) nach unten erstreckt und eine Breite aufweist, die von oben nach unten zunimmt, und wobei ein Boden des unteren Halbgrabens (222) konkav bogenförmig ist und ein Graben (220) durch den oberen Halbgraben (221) und den unteren Halbgraben gebildet wird (222) zusammen;
Bilden (S320) einer ersten Oxidschicht (223) auf einer Innenfläche des Grabens (220);
Ätzen (S330) der ersten Oxidschicht (223), um eine Seitenwand der ersten Oxidschicht (223) vertikal nach oben und unten zu ermöglichen;
Bilden (S340) einer zweiten Oxidschicht (224) auf der ersten Oxidschicht (223) am Boden des unteren Halbgrabens (222) unter Verwendung eines chemischen Dampfabscheidungsprozesses mit hochdichtem Plasma, so dass eine Floating-Gate-Oxidschicht, die durch die Kombination der ersten Oxidschicht (223) und der zweiten Oxidschicht (224) gebildet wird, entlang einer Seitenwand des unteren Halbgrabens (222) von oben nach unten dicker wird, und die Dicke der Floating-Gate-Oxidschicht an einem unteren Teil der Seitenwand des unteren Halbgrabens (222) gleich ist wie die der Floating-Gate-Oxidschicht am Boden des unteren Halbgrabens (222;
Abscheiden (S350) von Polysilizium in den Graben (220), um eine polykristalline Floating-Gate-Schicht (225) zu bilden;
Aufwachsen (S360) eines Isolationsmediums auf eine obere Oberfläche der polykristallinen Floating-Gate-Schicht (225), um eine Isolationsschicht (226) zu bilden; und Bilden eines Steuergates auf der Isolationsschicht in dem Graben (220).

2. Split-Gate-Vorrichtung mit Gräben, die Folgendes umfasst:
ein Halbleitersubstrat, in dem ein Graben (220) vorgesehen ist; wobei der Graben (210) einen oberen Halbgraben (221) und einen unteren Halbgraben (222) umfasst, der obere Halbgraben (221) vertikal nach oben und unten verläuft, der untere Halbgraben (222) sich von dem Boden des oberen Halbgrabens (221) nach unten erstreckt und eine Breite aufweist, die von oben nach unten zunimmt, und ein Boden des unteren Halbgrabens (222) konkav bogenförmig ist;
eine erste Oxidschicht (223), die auf einer Innenwand des Grabens (220) gebildet ist; wobei eine Seitenwand der ersten Oxidschicht (223) vertikal nach oben und unten verläuft;
eine zweite Oxidschicht (224), die auf der ersten Oxidschicht (223) am Boden des unteren Halbgrabens (222) gebildet ist, wobei eine Floating-Gate-Oxidschicht, die durch die Kombination der ersten Oxidschicht (223) und der zweiten Oxidschicht (224) gebildet ist, entlang einer Seitenwand des unteren Halbgrabens (222) von oben nach unten dicker wird und die Dicke der Floating-Gate-Oxidschicht an einem unteren Teil der Seitenwand des unteren Halbgrabens (222) gleich ist wie die der Floating-Gate-Oxidschicht am Boden des unteren Halbgrabens (222);
eine polykristalline Floating-Gate-Schicht (225), die auf einer Oberfläche der Floating-Gate-Oxidschicht gebildet ist;
eine Isolationsschicht (226), die auf einer oberen Oberfläche der polykristallinen Floating-Gate-Schicht (225) gebildet ist; und
ein Steuergate, das auf der Isolationsschicht (226) gebildet ist und dazu ausgelegt ist, das Ein- und Ausschalten der Vorrichtung zu steuern.

3. Split-Gate-Vorrichtung mit Gräben nach Anspruch 2, **dadurch gekennzeichnet, dass** eine Breite des unteren Halbgrabens (222) von einem Boden der Isolationsschicht (226) zu einer Position eines Bodens des unteren Halbgrabens (222) zunimmt.

## Revendications

1. Procédé de fabrication d'un dispositif à grille divisée en tranchée, comprenant :
la gravure (S300) d'un substrat semi-conducteur pour former une demi-tranchée supérieure verticale (221) ;
la gravure (S310) du substrat semi-conducteur obliquement vers le bas depuis un fond de la demi-tranchée supérieure (221) pour former une demi-tranchée inférieure (222) s'étendant vers le bas depuis le fond de la demi-tranchée supérieure (221) et avec une largeur qui augmente de haut en bas, un fond de la demi-tranchée inférieure (222) prenant la forme d'un arc concave, et une tranchée (220) étant constituée par la combinaison de la demi-tranchée supérieure (221) et de la demi-tranchée inférieure (222) ;
la formation (S320) d'une première couche d'oxyde (223) sur une surface interne de la tranchée (220) ;
la gravure (S330) de la première couche d'oxyde (223) pour rendre une paroi latérale de la première couche d'oxyde (223) verticale de haut en bas ;
la formation (S340) d'une deuxième couche d'oxyde (224) sur la première couche d'oxyde (223) au fond de la demi-tranchée inférieure (222) au moyen d'un procédé de dépôt chimique en phase vapeur assisté par plasma à haute densité, de telle sorte qu'une couche d'oxyde de grille flottante formée par la combinaison de la première couche d'oxyde (223) et de la deuxième couche d'oxyde (224) s'épaississe de haut en bas le long d'une paroi latérale de la demi-tranchée inférieure (222), et l'épaisseur de la couche d'oxyde de grille flottante dans une partie inférieure de la paroi latérale de la demi-tranchée inférieure (222) soit égale à celle de la couche d'oxyde de grille flottante au fond de la demi-tranchée inférieure (222) ;
le dépôt (S350) de silicium polycristallin à l'intérieur de la tranchée (220) pour former une couche polycristalline de grille flottante (225) ;
la croissance (S360) d'un milieu isolant sur une surface supérieure de la couche polycristalline de grille flottante (225) pour former une couche d'isolation (226) ; et
la formation d'une grille de commande sur la couche d'isolation dans la tranchée (220).

2. Dispositif à grille divisée en tranchée, comprenant :
un substrat semi-conducteur dans lequel une tranchée (220) est ménagée, la tranchée (210) comprenant une demi-tranchée supérieure (221) et une demi-tranchée inférieure (222), la demi-tranchée supérieure (221) étant verticale de haut en bas, la demi-tranchée inférieure (222) s'étendant vers le bas depuis le fond de la demi-tranchée supérieure (221) et avec une largeur qui augmente de haut en bas, et un fond de la demi-tranchée inférieure (222) prenant la forme d'un arc concave ;
une première couche d'oxyde (223) formée sur une paroi latérale de la tranchée (220), une paroi latérale de la première couche d'oxyde (223) étant verticale de haut en bas ;
une deuxième couche d'oxyde (224) formée sur la première couche d'oxyde (223) au fond de la demi-tranchée inférieure (222), une couche d'oxyde de grille flottante formée par la combinaison de la première couche d'oxyde (223) et de la deuxième couche d'oxyde (224) s'épaississant de haut en bas le long d'une paroi latérale de la demi-tranchée inférieure (222), et l'épaisseur de la couche d'oxyde de grille flottante dans une partie inférieure de la paroi latérale de la demi-tranchée inférieure (222) étant égale à celle de la couche d'oxyde de grille flottante au fond de la demi-tranchée inférieure (222) ;
une couche polycristalline de grille flottante (225) formée sur une surface de la couche d'oxyde de grille flottante ;
une couche d'isolation (226) formée sur une surface supérieure de la couche polycristalline de grille flottante (225) ; et
une grille de commande formée sur la couche d'isolation (226) conçue pour commander la mise en marche et l'arrêt du dispositif.

3. Dispositif à grille divisée en tranchée selon la revendication 2, **caractérisé en ce qu'**une largeur de la demi-tranchée inférieure (222) augmente depuis le bas de la couche d'isolation (226) jusqu'à la position du fond de la demi-tranchée inférieure (222).
